# EUROPEAN PATENT APPLICATION

(11) **EP 4 593 091 A1**
(43) Date of publication of application: **30.07.2025**
(21) Application number: 23883175.4
(22) Date of filing: 27.10.2023
(51) Int. Cl.: H01L 33/56, H01L 33/50, H01L 33/62, H01L 33/48

(54) **LIGHT-EMITTING DIODE PACKAGE**

(30) Priority: 27.10.2022 US 202263419761 P
(71) Applicant: Seoul Semiconductor Co., Ltd., Gyeonggi-do 15429 (KR)
(72) Inventor: HAN, Bo Yong, Ansan-si Gyeonggi-do 15429 (KR)
(74) Representative: Isarpatent
(86) International application number: PCT/KR2023/016900
(87) International publication number: WO 2024/091071

(57) **Abstract**

A light-emitting diode package is provided. The light-emitting diode package according to an embodiment comprises: a pair of leads; a housing surrounding the leads; a light-emitting diode electrically connected to the leads; and a sealing resin covering the light-emitting diode, wherein the sealing resin is spaced apart from the leads.

## Description

### [Technical Field]

The present disclosure relates to a light emitting diode package, and relates to a light emitting diode package that is configured to maintain high reliability even when used for a long time.

### [Background Art]

A light emitting diode package generally includes a lead for supplying power to a light emitting diode, a housing for providing a cavity, and an encapsulant resin for sealing the light emitting diode. The encapsulant resin also includes a wavelength conversion material for converting a wavelength of light emitted from the light emitting diode.

The lead is generally manufactured using a Cu lead frame in consideration of thermal and electrical conductivity. Furthermore, in order to reduce loss of light emitted from the light emitting diode and wavelength-converted light, a plating layer having high reflectivity such as Ag is added to a surface of the lead. However, a metallic reflection layer such as Ag is vulnerable to moisture and has a disadvantage that reflectance decreases over time.

The encapsulant resin encapsulates the light emitting diode so as to protect the light emitting diode from the external environment. The encapsulant resin is formed of a transparent resin through which light emitted from the light emitting diode can pass, and a silicone resin is generally used. A methyl-based silicone resin or a phenyl-based silicone resin is used. The methyl-based silicone resin is vulnerable to water penetration and cannot protect the Ag plating layer from moisture, and has a relatively low refractive index, which limits an ability to increase light extraction efficiency.

Meanwhile, the phenyl-based silicone resin is generally a mixture of methyl-based and phenyl-based components, and the phenyl-based component contains 40 wt% to 50 wt% of a total resin. The phenyl-based component increases the refractive index of the silicone resin and improves a moisture resistance of the silicone resin. Accordingly, it is widely used as a resin for preventing moisture permeation. However, the phenyl-based silicone resin has a disadvantage of discoloration depending on light emitted from the light emitting diode. Since the phenyl-based silicone resin is easily discolored by short-wavelength light such as violet light or ultraviolet light, its use is limited depending on a type of light emitting diode. For example, in a case of a package including a short-wavelength blue light emitting diode of 450 nm or less, a purple light emitting diode, or an ultraviolet light emitting diode, the phenyl-based silicone resin cannot be used for a long time because it is discolored by light emitted from the light emitting diode.

### [Disclosure]

### [Technical Problem]

Exemplary embodiments provide a light emitting diode package that is configured to maintain high light extraction efficiency even when used for a long time.

Exemplary embodiments provide a light emitting diode package that is configured to prevent a decrease in light extraction efficiency due to moisture permeation while preventing discoloration of a silicone resin by a light emitting diode.

### [Technical Solution]

A light emitting diode package according to an embodiment of the present disclosure includes a pair of leads; a housing surrounding the leads; a light emitting diode electrically connected to the leads; and an encapsulant resin covering the light emitting diode, in which the encapsulant resin is spaced apart from the leads.

Lower surfaces of the leads may be exposed from a lower surface of the housing.

In an embodiment, the housing may be formed of a white epoxy molding compound.

Meanwhile, the encapsulant resin may be formed a methyl-based silicone resin or a middle refractive index silicone resin including a phenyl-based component and having a refractive index of 1.5 or less.

The encapsulant resin may include a wavelength conversion material.

The light emitting diode may emit light having a peak wavelength of 450 nm or less. In an embodiment, the light emitting diode may emit light having a peak wavelength within a range of 400 nm to 450 nm.

The pair of leads may include a light emitting diode mounting portion; and an upper recess portion, in which the light emitting diode may be bonded onto the light emitting diode mounting portion, and the housing may fill the upper recess portion.

The pair of leads may include upper recess portions, respectively, and the light emitting diode mounting portion may be surrounded by the upper recess portions and a separation space of the leads.

Furthermore, the leads may further include a lower recess portion, respectively, and the housing may fill the lower recess portion.

A depth of the upper recess portion may be smaller than a depth of the lower recess portion.

The housing may have a cavity surrounded by inner side surfaces, and an inlet width W2 of the cavity may be greater than a width W4 of a bottom surface of the cavity.

A width W3 of an upper surface of the housing disposed between the cavity and a side surface of the housing may be in a range of 0.15 mm to 0.2 mm.

The inner side surface of the cavity may include a relatively steep inner side surface and a relatively gentle inner side surface, and the relatively gentle inner side surface may be spaced apart from the bottom surface of the cavity.

The relatively gentle inner side surface may be disposed between the relatively steep inner side surfaces.

A light emitting diode package according to an embodiment of the present disclosure includes a pair of leads; a housing surrounding the leads and having a cavity; a light emitting diode electrically connected to the leads; and an encapsulant resin covering the light emitting diode, in which each of the leads includes a light emitting diode mounting portion exposed to the cavity and an upper recess portion formed around the light emitting diode mounting portion, in which the upper recess portion is covered by the housing, and the light emitting diode mounting portion is covered by the light emitting diode.

An edge of a bottom surface of the cavity may be disposed on the upper recess portion.

Upper surfaces of the leads excluding the light emitting diode mounting portion may be covered with the housing.

The encapsulant resin may include a wavelength conversion material, in which the light emitting diode may emit light having a peak wavelength within a range of 400 nm to 450 nm, and the housing may be formed of a white epoxy molding compound. Furthermore, the encapsulant resin may be formed of a methyl-based silicone resin or a middle refractive index silicone resin including a phenyl-based component and having a refractive index of 1.5 or less.

Bottom surfaces of the leads may occupy 50% or more of a bottom surface of the light emitting diode package.

In an embodiment, edges of the bottom surface of the cavity may be disposed on the upper recess portions.

### [Description of Drawings]

FIG. 1 is a schematic plan view illustrating a light emitting diode package according to an embodiment of the present disclosure.
FIG. 2 is a schematic cross-sectional view taken along line A-A' of FIG. 1.
FIG. 3 is a schematic cross-sectional view taken along line B-B' of FIG. 1.
FIG. 4 is a schematic cross-sectional view illustrating a light emitting diode package according to another embodiment of the present disclosure.
FIG. 5 is a schematic cross-sectional view illustrating a light emitting diode package according to another embodiment of the present disclosure.
FIG. 6 is a schematic cross-sectional view illustrating a light emitting diode package according to another embodiment of the present disclosure.
FIG. 7 is a schematic plan view illustrating a light emitting diode package according to another embodiment of the present disclosure.

### [Best Mode]

Hereinafter, embodiments will be described in detail with reference to the accompanying drawings. The following embodiments are provided by way of example so as to fully convey the spirit of the present disclosure to those skilled in the art to which the present disclosure pertains. Accordingly, the inventive concepts are not limited to the embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

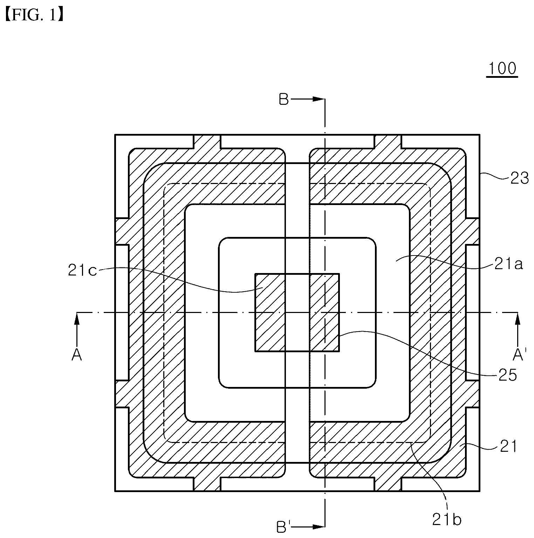

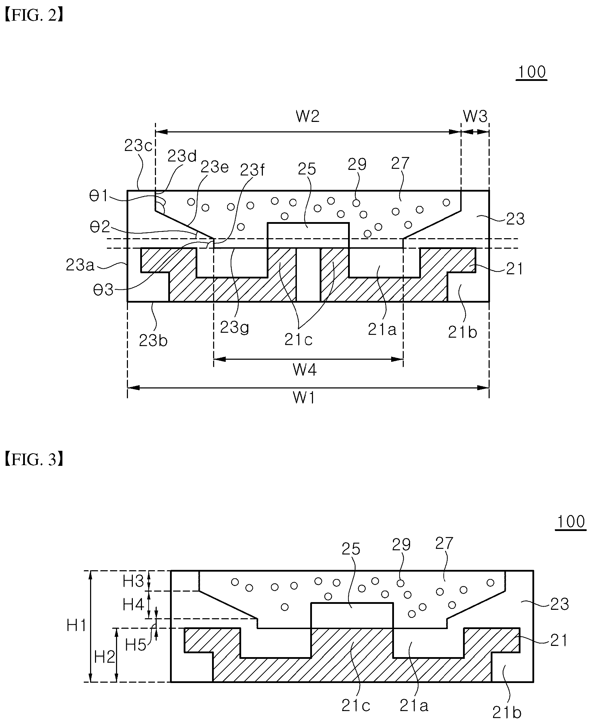

FIG. 1 is a schematic plan view illustrating a light emitting diode package 100 according to an embodiment of the present invention, FIG. 2 is a schematic cross-sectional view taken along line A-A' of FIG. 1, and FIG. 3 is a schematic cross-section taken along line B-B' of FIG. 1.

Referring to FIGS. 1 through 3, the light emitting diode package 100 according to this embodiment may include a pair of leads 21, a housing 23, a light emitting diode 25, an encapsulant resin 27, and a wavelength conversion material 29.

The leads 21 may be manufactured using a copper plate frame. Each of the leads 21 may include an upper recess portion 21a recessed from an upper surface, a lower recess portion 21b recessed from a lower surface, and a light emitting diode mounting portion 21c.

The upper surface of the lead 21 may be coated with a reflection layer such as Ag, or the like as in a prior art, but coating of the reflection layer may be omitted. That is, in the embodiments of the present disclosure, the lead 21 does not require a metallic reflection layer, and Cu may be exposed on the upper surface of the lead 21.

The lower surface of the lead 21 occupies most of a lower surface of the light emitting diode package 100. For example, a total area of the lower surface of the leads 21 exceeds 1/2 of the lower surface of the light emitting diode package 100, and may occupy more than 70%. As the lower surface of the lead 21 is exposed more to the lower surface of the light emitting diode package 100, heat generated by the light emitting diode 25 may be better transferred, thereby improving heat dissipation efficiency of the light emitting diode package 100.

The upper recess portion 21a is recessed on the upper surface of the lead 21, and the lower recess portion 21b is recessed on the lower surface of the lead 21. The upper and lower recess portions 21a and 21b may be formed using a pressing technique or an etching technique. In an embodiment, the upper and lower recess portions 21a and 21b may be formed using a half-cutting technique using etching. A depth of the upper recess portion 21a may be 1/3 or more and 2/3 or less of a total thickness of the lead 21. A depth of the lower recess portion 21b may be greater than 1/2 and less than 2/3 of the total thickness of the lead 21. In an embodiment, the depth of the upper recess portion 21a may be smaller than that of the lower recess portion 21b. For example, when the total thickness of the lead 21 is about 0.5 mm, the depth of the upper recess portion 21a may be about 0.25 mm, and the depth of the lower recess portion 21b may be about 0.3 mm.

The light emitting diode mounting portions 21c may be formed on the respective leads 21. However, the present disclosure is not limited thereto, and the light emitting diode mounting portion 21c may be formed on any one of the leads 21. The light emitting diode mounting portion 21c may have a size covered with the light emitting diode 25. The light emitting diode mounting portions 21c may be disposed within an area smaller than that of the light emitting diode. A length of each of the light emitting diode mounting portions 21c in a direction of a long axis may be about three times of a width in a direction of a short axis, and a distance between the light emitting diode mounting portions 21c may be similar to or same as the width of the light emitting diode mounting portions 21c in the direction of the short axis. The length of the light emitting diode mounting portion 21c in the direction of the long axis may be 100% or less, 95% or less, further 90% or less of a length of one side of the light emitting diode. For example, the light emitting diode may have an area of about 1 mm × 1 mm, and the light emitting diode mounting portions 21c may be disposed within an area of 0.9 mm × 0.9 mm.

As shown in FIG. 1, the pair of leads 21 are spaced apart from each other, and thus, the separation space may be formed. A width of the separation space may be substantially similar to the width in the short axis direction of the light emitting diode mounting portion 21c. In an embodiment, the light emitting diode mounting portions 21c may be disposed in contact with the separation space, and thus, may be surrounded by the upper recess portion 21a and the separation space of the leads 21. However, the present disclosure is not limited thereto, and the light emitting diode mounting portion 21c may be disposed away from the separation space of the leads 21, and the upper recess portion 21a may surround an entire periphery of the light emitting diode mounting portion 21c.

The lower recess portions 21b may be formed along an edge of the lead 21. The lower recess portions 21b may be formed so as to prevent the leads 21 from being separated from the housing 23.

In this embodiment, the pair of leads 21 may have a structure symmetrical to each other. However, the present disclosure is not limited thereto, and the pair of leads 21 may be asymmetrical to each other. In addition, the light emitting diode mounting portions 21c may be disposed on the leads 21 to form a symmetrical structure, respectively, but the present disclosure is not limited thereto.

The housing 23 surrounds the leads 21. The housing 23 may cover the upper surfaces of the leads 21 and may fill the upper recess portions 21a. The housing 23 may also fill the separation space between the leads 21, and may fill the lower recess portions 21b. The housing 23 may also cover most or all of the side surfaces of the leads 21. That is, the side surfaces of the leads 21 may be generally disposed inside the housing 23. However, the leads 21 may include protrusions that partially protrude on the side surfaces, and these protrusions may be exposed to the outside from the side surfaces of the housing 23.

However, the housing 23 surrounds the leads 21 so as to expose the light emitting diode mounting portions 21c. Most upper surfaces of the leads 21 are covered with the housing 23, but the light emitting diode mounting portions 21c are not covered with the housing 23. The housing 23 provides a cavity for forming the encapsulant resin 27, and the light emitting diode mounting portions 21c may be exposed to a bottom of the cavity. Only the light emitting diode mounting portions 21c of the upper surfaces of the leads 21 may be exposed to the bottom surface of the cavity formed by the housing 23. Further, all upper surfaces of the leads 21 except for the light emitting diode mounting portions 21c may be covered with the housing 23. Furthermore, the upper recess portions 21a of the leads 21 are filled with the housing 23, and thus, other parts of the leads 21 except for the light emitting diode mounting portions 21c are not exposed to the cavity of the housing 23.

The housing 23 may be formed of a molding resin having a relatively high reflectance. For example, the housing 23 may be formed of poly phthal amide (PPA), poly cyclohexylenedimethylene terephthalate (PCT), epoxy molding compound (EMC), or silicone molding compound (SMC). For example, the housing 23 may be formed of a white epoxy molding compound (EMC). The white EMC has a high reflectance for light emitted from the light emitting diode 25 and light generated from the wavelength conversion material 27, and thus, a light extraction efficiency of the light emitting diode package 100 may be improved.

Furthermore, since the white EMC is resistant to moisture and is not discolored by light emitted from the light emitting diode 25, it may maintain high reliability even when used for a long time. In particular, since the surfaces of the leads 21 are not exposed at all to the cavity of the housing 23 except for the light emitting diode mounting portions 21c, the surfaces of the leads 21 may be protected from moisture by the housing 23. Since the light emitting diode mounting portions 21c, which are portions to which the light emitting diode 25 is bonded, may not be exposed to the outside and, furthermore, they are not portions that reflect light, so that even when the light emitting diode mounting portions 21c are exposed, they do not adversely affect the light extraction efficiency of the light emitting diode package 100.

The housing 23 may include a side surface 23a, a lower surface 23b, an upper surface 23c, inner side surfaces 23d, 23e, and 23f, and a bottom surface 23g. The side surface 23a of the housing 23 may be a vertical surface, without being limited thereto. A protrusion of the lead 21 may be exposed through the side surface 23a of the housing 23. The lower surface 23b of the housing 23 may be flush with the lower surface of the lead 21. However, the present disclosure is not limited thereto, and the lower surface of the lead 21 may protrude downward from the lower surface 23b of the housing 23.

The upper surface 23c of the housing 23 surrounds the cavity of the housing 23. A width of the upper surface may be formed smaller than that of the bottom surface. The inner side surfaces 23d, 23e, and 23f and the bottom surface 23g form the side surfaces and bottom surface of the cavity. The inner side surfaces 23d, 23e, and 23f may include a plurality of surfaces having different slopes. The inner side surface 23d may continue from the upper surface 23c, and the inner side surface 23f may continue from the bottom surface 23g. The inner side surface 23e may be disposed between the inner side surfaces 23d and 23f. The inner side surface 23d and the inner side surface 23f may form steeper inclined surfaces than that of the inner side surface 23e, and may be vertical. The inner side surface 23e may form a relatively gentle inclined surface. Based on the housing bottom surface 23g, the inner side surface 23f may be formed lower than the upper surface of the light emitting diode 25. A height from the housing bottom surface 23g to a top of the inner side surface 23f may be about 50 um or more and 120 um or less. Also, a height of the inner side surface 23f may be less than 1/2 of a height of a chip mounted on the housing. The inner side surface 23d and the inner side surface 23e may be connected while forming a first angle 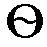 1. The inner side surface 23e may be connected to the inner side surface 23f while forming a second angle 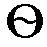 2 with respect to the housing bottom surface 23g. In addition, the inner side surface 23f form a third angle 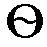 3 with respect to the housing bottom surface 23g. The second angle 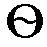 2 and the third angle 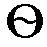 3 may mean values measured based on an imaginary line parallel to the housing bottom surface 23g. Accordingly, the first angle 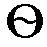 1 may be formed equal to or larger than the third angle 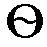 3 and the third angle 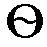 3 may be formed equal to or larger than the second angle 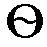 2. The first angle 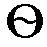 1 may be 95 degrees or more and 150 degrees or less, specifically, 105 degrees or more and 140 degrees or less. The second angle 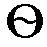 2 may be 15 degrees or more and 65 degrees or less, specifically, 30 degrees or more and 45 degrees or less. The third angle 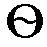 3 may be 75 degrees or more and 130 degrees or less, specifically, 80 degrees or more and 120 degrees or less. However, the present disclosure is not limited thereto, and at least one inner side surface of the inner side surface 23d or 23f may be omitted. As such, by forming the inner side surfaces with various angles on the side surfaces of the housing, a luminous efficiency of a light emitting apparatus may be improved, and a reliability of the light emitting apparatus may be increased by improving a coupling force between the housing and a molding member disposed in the housing.

The bottom surface 23g may be positioned at a same height as or lower than that of the light emitting diode mounting portion 21c. The upper surface of the light emitting diode mounting portion 21c may be flush with the bottom surface 23g or may protrude upward from the bottom surface 23g.

The light emitting diode package 100 may have a substantially rectangular or square shape, and the housing 23 forms an outer shape of the light emitting diode package 100. The housing 23 has a width W1 in one direction, and for example, the width W1 may be about 3 mm.

An upper width W2 of the cavity is smaller than a maximum width W1 of the housing 23, the upper surface 23c is disposed between the cavity and the side surface of the housing 23, and the upper surface 23c has a width W3. To increase an area of the cavity, the width W3 of the upper surface 23c may be adjusted to be small. For example, the upper width W2 of the cavity may exceed 5/6 of the width W1, and may further exceed 7/8 of the width W1. Meanwhile, the upper width W2 of the cavity may be less than 9/10, and further less than 8/9 of the width W1. When the width W1 is 3 mm, the upper width W2 of the cavity may be greater than 2.5 mm and less than 2.7 mm, for example.

The width W3 may be less than 1/12 of the width W1, and may be less than 1/16 of the width W1. In addition, a lower limit of the width W3 is not particularly limited. However, to structurally maintain stability and prevent light leakage, the width W3 may be 0.15 mm or more. The width W3 may be, for example, greater than or equal to 0.15 mm and less than 0.25 mm, and further, greater than or equal to 0.17 mm and less than or equal to 0.2 mm.

The width W4 of the bottom surface 23g of the cavity of the housing 23 is smaller than the upper width W2 of the cavity. By making the width of the bottom surface 23g smaller than the upper width W2, an inclined inner side surface 23e may be provided, and at the same time, the upper surface of the lead 21 may be prevented from being exposed. For example, the width W4 of the bottom surface 23g may be greater than 1/2 of the upper width W2. Edges of the cavity bottom surface 23g may be disposed so as to surround the light emitting diode mounting portions 21c of the leads 21, and may be disposed on the upper recess portion 21a of the lead 21. By disposing the edge of the cavity bottom surface 23g on the upper recess portion 21a, it is possible to easily prevent the upper surface of the lead 21 from being exposed in the cavity.

Meanwhile, the housing 23 may have a height H1, and the height H is a distance from the lower surface 23b to the upper surface 23c. The height H1 of the housing 23 may be same as a height of the light emitting diode package 100, but the present disclosure is not necessarily limited thereto. For example, the height of the light emitting diode package 100 may be greater than the height H1 of the housing 23.

Meanwhile, the leads 21 have a height H2, and the height H2 may be less than 1/2 of the height H1. A height from the upper surface of the lead 21 to the upper surface 23c of the housing 23 may be greater than the height H2 of the lead 21.

Meanwhile, as described above, the inner side surfaces 23d, 23e, and 23f may include the plurality of surfaces having different slopes. The inner side surface 23d may continue from the upper surface 23c, and the inner side surface 23f may continue from the bottom surface 23g. The inner side surface 23e may form a most gentle inclined surface among the inner side surfaces, and may be disposed between the inner side surfaces 23d and 23f. The inner side surfaces 23d, 23e, and 23f and the bottom surface 23g reflect light emitted from the light emitting diode 25 and the wavelength conversion material 29 to improve the light extraction efficiency of the light emitting diode package 100.

Meanwhile, if a height of the inner surface 23d is H3, a height of the inner surface 23e is H4, and a height of the inner surface 23f is H5, a height from the bottom surface 23g of the cavity of the housing 23 to the upper surface 23c of the housing 23 may be a sum of vertical heights of the inner surfaces 23d, 23e, and 23f of the cavity, that is, H3+H4+H5. A total height of the inner side surfaces 23d, 23e, and 23f may exceed 1/2 of the height H1 of the housing 23 and may be about 2/3 of the height H1. In this embodiment, the inner side surface 23d and the inner side surface 23f are formed so as to enhance an adhesion of the encapsulant resin 27. Furthermore, the inner side surface 23f increases a distance between the upper surface of the lead 21 and the inner side surface 23e to assist preventing the upper surface of the lead 21 from being exposed. The height H5 of the inner side surface 23f may be, for example, 0.03 mm or more and 0.1 mm or less.

As shown in FIG. 3, the height H4 of the inner side surface 23e may be greater than the height H3 of the inner side surface 23d and the height H5 of the inner side surface 23f. The height H3 of the inner side surface 23d may also be greater than the height H5 of the inner side surface 23f. The inner side surface 23d and 23f may be omitted, and the inner side surface 23e may connect the upper surface 23c of the housing 23 and the bottom surface 23g of the cavity.

The light emitting diode 25 may be disposed on the light emitting diode mounting portions 21c. The light emitting diode 25 may be a flip chip type light emitting diode, and as shown in FIGS. 2 and 3, it may be flip-bonded to the light emitting diode mounting portions 21c without using a bonding wire. Alternatively, the light emitting diode 25 may be a lateral type or vertical type light emitting diode, and at least one bonding wire may be used to electrically connect the light emitting diode 25 to the leads 21.

An area of the light emitting diode 25 may be larger than those of the light emitting diode mounting portions 21c, and the light emitting diode 25 may completely cover the light emitting diode mounting portions 21c. However, the present disclosure is not necessarily limited thereto, and a portion of the light emitting diode mounting portions 21c may be exposed to the outside of the light emitting diode 25. The light emitting diode 25 may be mounted on the light emitting diode mounting portions 21c using various bonding methods such as solder paste and eutectic bonding.

In this embodiment, the light emitting diode 25 is an inorganic light emitting diode formed of a nitride-based semiconductor, may have a peak wavelength within a range of about 400 nm to about 450 nm, and furthermore, may have a peak wavelength within a range of about 410 nm to about 430 nm. The light emitting diode may be, for example, a short-wavelength blue light emitting diode having a peak wavelength of 450 nm or less, a purple light emitting diode, or an ultraviolet light emitting diode.

The encapsulant resin 27 is disposed in the cavity of the housing 23 to cover the light emitting diode 25. The encapsulant resin 27 may include the wavelength conversion material 29.

The encapsulant resin 27 may be, for example, a methyl-based silicone resin or a middle refractive index (MRI) silicone resin in which a phenyl-based component is in a range of 20 wt% to 40 wt% of a total silicone resin. The methyl-based silicone resin has a refractive index of about 1.41, and the phenyl-based silicone resin has a refractive index of about 1.54. The middle refractive index silicone resin may have a refractive index between 1.41 and 1.54 through an adjustment of the phenyl-based component, and in particular, may have the refractive index of 1.5 or less. A light extraction efficiency of the light emitting diode package 100 may be increased by using the middle refractive index silicone resin having a relatively higher refractive index than that of the methyl-based silicone resin. However, since there is a concern that the middle refractive index silicone resin may be discolored when a light output emitted from the light emitting diode 25 is high, the methyl-based silicone resin or the middle refractive index silicone resin may be selected as a material for the encapsulant resin 27 in consideration of the light output. For example, in a case of a low power light emitting diode package having an output power of about 0.2 W, high reliability may be maintained for a long time even when the MRI silicone resin is used. When the output power is 1W or more, there is a concern that the phenyl-based component may be discolored by light emitted from the light emitting diode 25, and in this case, the encapsulant resin 27 may be formed of the methyl-based silicone resin.

In this embodiment, the encapsulant resin 27 is spaced apart from the leads 21. That is, the encapsulant resin 27 and the leads 21 do not contact each other. The upper surfaces of the leads 21 excluding the light emitting diode mounting portions 21c may be covered with the housing 23 and spaced apart from the encapsulant resin 27. Since the upper surfaces of the leads 21 are covered using the housing 23, even when moisture permeates through the encapsulant resin 27, the surfaces of the leads 21 may be prevented from being damaged. Moreover, since the housing 23 is formed using the material that has high reflectivity and is resistant to moisture, such as the epoxy molding compound, even when the encapsulant resin 27 is formed using the methyl-based silicone resin that is weak to moisture permeation, it is possible to maintain the light extraction efficiency of the light emitting diode package 100.

Meanwhile, the wavelength conversion material 29 may include phosphors and/or quantum dots. For example, blue, green, and red phosphors may be dispersed in the encapsulant resin 27, and thus, a white light emitting diode package may be provided. In addition to phosphors, perovskite or quantum dots may be used as the wavelength conversion material 29.

Examples of the blue phosphor may include BAM-based, Halo-Phosphate-based, or Aluminate-based phosphors, and for example, BaMgAl₁₀O₁₇:Mn²⁺, BaMgAl₁₂O₁₉:Mn²⁺ or (Sr,Ca,Ba)PO₄Cl:Eu²⁺ may be included. The blue phosphor may have a peak wavelength within a range of 440 to 500 nm, for example.

Examples of the green or yellow phosphor may include LuAG(Lu₃(Al,Gd)₅O₁₂:Ce³⁺), YAG(Y₃(Al,Gd)₅O₁₂:Ce³⁺), Ga-LuAG((Lu,Ga)₃(Al,Gd)₅O₁₂:Ce³⁺), Ga-YAG ((Ga,Y)₃(Al,Gd)₅O₁₂:Ce³⁺), LuYAG ((Lu,Y)₃(Al,Gd)₅O₁₂:Ce³⁺), Ortho-Silicate ((Sr,Ba,Ca,Mg)₂SiO₄:Eu²⁺), Oxynitride ((Ba,Sr,Ca)Si₂O₂N₂:Eu²⁺), SiAlON, or Thio Gallate (SrGa₂S₄:Eu²⁺) and the like. The green or yellow phosphor may have a peak wavelength within a range of 500 nm to 600 nm.

The red phosphor may have a peak wavelength within a range of 600 nm to 700 nm, for example. Examples of the red phosphor may include a UOX (Y₂O₃:EU)-based phosphor composed of a compound of Yttrium oxide (Y₂O₃) and Europium (EU), Nitride, Sulfide, Fluoride, Oxyfluoride or Oxynitride- based phosphors. Specifically, CASN (CaAlSiN₃:Eu²⁺), (Ba,Sr,Ca)₂Si₅N₈:Eu²⁺, (Ca,Sr)S₂:Eu²⁺), (Sr,Ca)₂SiS₄:Eu²⁺, Mn⁴⁺ Fluoride compound KSF phosphor (K₂SiF₆), and the like may be included. In addition, the red phosphor may be an Mn(IV)-activated luminescent materials based on an oxidohalide host lattice. The Mn(IV)-activated luminescent materials based on oxidohalide host lattices may have an emission maximum in a range between 610 nm and 640 nm, a high quantum yield, a high color rendering and stability and may be expressed by a general formula (I) or (II) as follows:

(A₄₋ₐBₐ)_{m/2+n/2}X₂ₘ[MX₄O₂]ₙ (I)

Ais selected from a group consisting of H and D and mixtures thereof, wherein D is deuterium; B is selected from a group consisting of Li, Na, K, Rb, Cs, NH₄, ND₄, NR₄ and mixtures of two or more thereof, wherein R is an alkyl or aryl radical; X is selected from a group consisting of F and Cl and mixtures thereof; M is selected from a group consisting of Cr, Mo, W, Re and mixtures of two or more thereof; 0 ≤ a ≤ 4; 0 < m ≤ 10; and 1 ≤ n ≤ 10.

A₃BF₂M₁₋ₓTₓO₂₋₂ₓF_{4 +2x} (II)

A is selected from a group consisting of H and D and mixtures thereof, wherein D is deuterium; B is selected from a group consisting of Li, Na, K, Rb, Cs, Cu, Ag, Ti, NH₄, ND₄, NR₄ and mixtures of two or more thereof, wherein R is an alkyl or aryl radical; M is selected from a group consisting of Cr, Mo, W, Re and mixtures of two or more thereof; T is selected from a group consisting of Si, Ge, Sn, Ti, Pb, Ce, Zr, Hf and mixtures of two or more thereof; 0 ≤ x ≤ 1.

When an amount of the wavelength conversion material 29 contained in the encapsulant resin 27 increases, a viscosity of the encapsulant resin 27 increases and a surface roughness of the encapsulant resin 27 increases. The increase in the viscosity of the encapsulant resin 27 makes a process of forming the encapsulant resin 27, such as a dispensing process, difficult. To lower the viscosity of the encapsulant resin 27, a total amount of the wavelength conversion material 29 included in the cavity may be increased by increasing the cavity area of the housing 23, and through this, the viscosity of the encapsulant resin 27 may be reduced by reducing the amount of the wavelength conversion material 29 contained in a unit volume of the encapsulant resin 27.

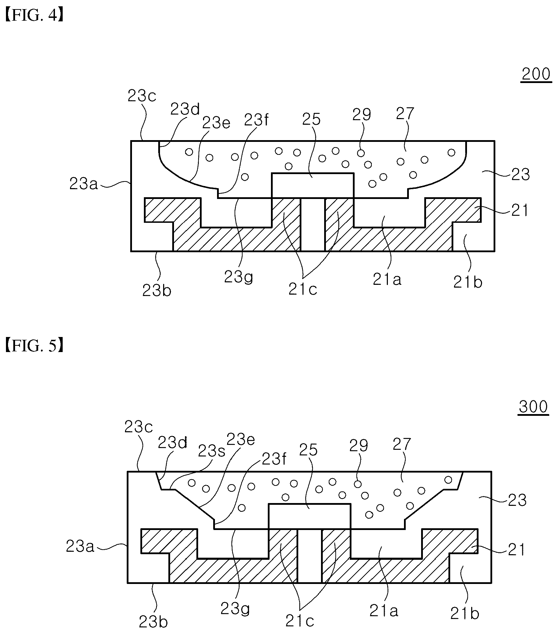

FIG. 4 is a schematic cross-sectional view illustrating a light emitting diode package 200 according to another embodiment of the present disclosure.

Referring to FIG. 4, the light emitting diode package 200 according to this embodiment is similar to the light emitting diode package 100 described with reference to FIGS. 1 through 3, except that the inner side surface 23e of the cavity forms a curved surface. The inner side surface 23e may form a concave curved surface. Since the inner side surface 23e has the concave curved shape, light emitted from the light emitting diode 25 may be better reflected toward the outside of the light emitting diode package 200 from the inner side surface 23e, and thus, the light extraction efficiency may be improved.

FIG. 5 is a schematic cross-sectional view illustrating a light emitting diode package 300 according to another embodiment of the present disclosure.

Referring to FIG. 5, the light emitting diode package 300 according to this embodiment is similar to the light emitting diode package 100 described with reference to FIGS. 1 through 3, except that an inner side surface of the cavity includes a step portion 23s.

The step portion 23s may be formed so as to be substantially parallel to the housing bottom surface 23g. An inner side surface 23d may be inclined so as to form an obtuse angle with the step portion 23s. The step portion 23s may be positioned between the inner side surface 23d and the inner side surface 23e, without being limited thereto. For example, the step portion 23s may be disposed in a middle of the inner side surface 23d. The step portion 23s may be positioned higher than the upper surface of the light emitting diode 25 based on the bottom surface 23g. The step portion 23s may have a width equal to or larger than the width W3 of the upper surface 23c of the housing. In addition, the step portion 23s may be formed smaller than the width of the light emitting diode 25. In this way, when the step portion 23s is formed on the side surface of the housing, a luminous efficiency of the light emitting diode package 300 may be improved, and a reliability of the light emitting diode package may be increased by improving a coupling force between a molding member 27 disposed in the housing and the housing 23.

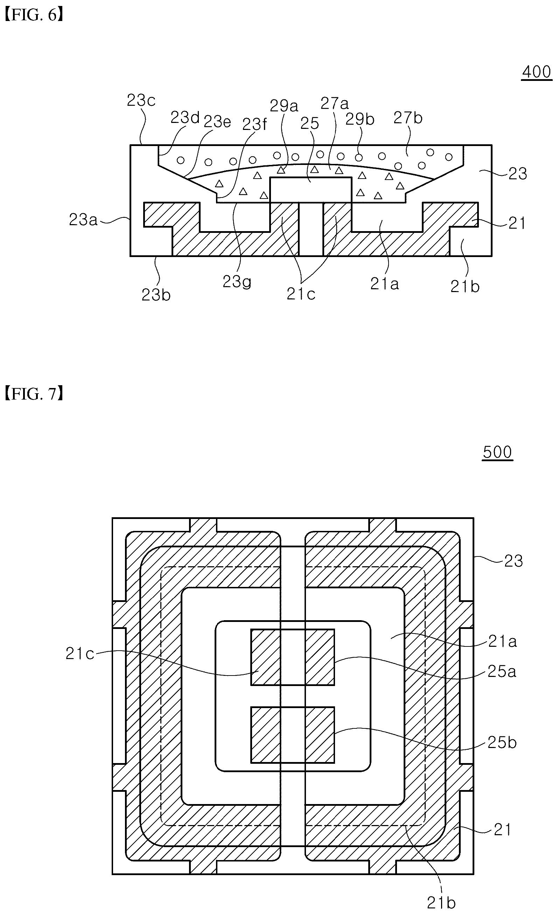

FIG. 6 is a schematic cross-sectional view illustrating a light emitting diode package 400 according to another embodiment of the present disclosure.

Referring to FIG. 6, the light emitting diode package 400 includes wavelength conversion materials 29a and 29b disposed in different encapsulant resins 27a and 27b. In the previous embodiments, the wavelength conversion material 29 has been exemplarily described as being included in a single encapsulant resin 27, but the present disclosure is not limited thereto.

That is, as in the previous embodiments, a single wavelength conversion layer in which the wavelength conversion material 29 is dispersed in a single-layer encapsulation resin 27 may cover an upper portion of the light emitting diode, and multi-layer wavelength conversion layers in which the wavelength conversion materials 29a and 29b are dispersed in a plurality of encapsulant resins 27a and 27b may cover the upper portion of the light emitting diode.

When the single-layer wavelength conversion layer is used, the wavelength conversion material 29 may be dispersed over an entire region of the encapsulant resin 27, and the wavelength conversion material 29 may be concentrated in a lower region and a clear region in which the wavelength conversion material is sparse or absent may be present in an upper region of the encapsulant resin 27. An interface roughened by the wavelength conversion material 29 may be formed between the region where the wavelength conversion material 29 is concentrated and the clear region. The roughened interface has a higher roughness than that of an upper surface of the encapsulant resin 27.

As shown in FIG. 6, when the multi-layer wavelength conversion layer is used, a first layer 27a disposed so as to contact the light emitting diode 25 and a second layer 27b disposed in an upper region of at least a portion of the first layer 27a may be included. The wavelength conversion material 29a may be dispersed over an entire region of the first layer 27a, or alternatively, the first layer 27a may include a region in which the wavelength conversion material 29a is concentrated and a clear region in which the wavelength conversion material is sparse or absent. The wavelength conversion material 29b may be dispersed over an entire region of the second layer 27b, or alternatively, the second layer 27b may include a region in which the wavelength conversion material 29b is concentrated and a clear region in which the wavelength conversion material is sparse or absent. An interface roughened by the wavelength conversion materials 29a and 29b may be formed between the region where the wavelength conversion materials 29a and 29b are concentrated in the first layer 27a and the second layer 27b and the clear region. Herein, the roughened interface has a greater roughness than those of upper surfaces of the first layer 27a and the second layer 27b. The first layer 27a and the second layer 27b may include different wavelength conversion materials or different combinations of wavelength conversion materials. Furthermore, the wavelength conversion material 29a and the wavelength conversion material 29b may include wavelength conversion materials that overlap at least portions of color regions, or may include wavelength conversion materials that do not overlap each other.

FIG. 7 is a schematic plan view illustrating a light emitting diode package 500 according to another embodiment of the present disclosure.

Referring to FIG. 7, the light emitting diode package 500 according to this embodiment is generally similar to the light emitting diode package 100 described with reference to FIGS. 1 through 3, except that a plurality of light emitting diodes 25a and 25b is included.

To mount the plurality of light emitting diodes 25a and 25b, the lead 21 may include a plurality of pairs of light emitting diode mounting portions 21c.

Meanwhile, the plurality of light emitting diodes 25a and 25b may include, for example, a first light emitting diode 25a and a second light emitting diode 25b. The first light emitting diode 25a and the second light emitting diode 25b may have different center wavelengths. For example, a center wavelength of the first light emitting diode 25a may be within a range of 400 nm to 450 nm, and a center wavelength of the second light emitting diode 25a may be within a range of 420 nm to 470 nm. In addition, full widths at half maximum of light emitted from the first light emitting diode 25a and the second light emitting diode 25b may be different from each other. For example, the full width at half maximum of light emitted from the first light emitting diode 25a may be between 5 nm and 28 nm, and the full width at half maximum of light emitted from the second light emitting diode 25b may be between 7 nm and 32 nm.

In an embodiment, a spectrum of light emitted from the first light emitting diode 25a and a spectrum of light emitted from the second light emitting diode 25b may partially overlap. For example, a longer wavelength side tail of light emitted from the first light emitting diode 25a and a shorter wavelength side tail of the second light emitting diode 25b may overlap within a range of about 10 nm to 120 nm, and an area of a portion where they overlap may be 97% or less of an area of the spectrum of light emitted from the first light emitting diode 25a or the second light emitting diode 25b.

Although various embodiments of the present invention have been described above, the present invention is not limited to these embodiments, and various modifications may be made without departing from the scope of the present invention.

## Claims

1. A light emitting diode package, comprising:
a pair of leads;
a housing surrounding the leads;
a light emitting diode electrically connected to the leads; and
an encapsulant resin covering the light emitting diode,
wherein the encapsulant resin is spaced apart from the leads.

2. The light emitting diode package of claim 1,
wherein lower surfaces of the leads are exposed from a lower surface of the housing.

3. The light emitting diode package of claim 1,
wherein the housing is formed of a white epoxy molding compound.

4. The light emitting diode package of claim 1,
wherein the encapsulant resin is formed of a methyl-based silicone resin or a middle refractive index silicone resin including a phenyl-based component and having a refractive index of 1.5 or less.

5. The light emitting diode package of claim 4,
wherein the encapsulant resin includes a wavelength conversion material.

6. The light emitting diode package of claim 5,
wherein the light emitting diode package emits light having a peak wavelength in a range of 400 nm to 450 nm.

7. The light emitting diode package of claim 1,
the pair of leads, comprising:
a light emitting diode mounting portion; and
an upper recess portion, wherein:
the light emitting diode is bonded onto the light emitting diode mounting portion, and
the housing fills the upper recess portion of the light emitting diode package.

8. The light emitting diode package of claim 7,
wherein the pair of leads include upper recess portions, respectively, and the light emitting diode mounting portion is surrounded by the upper recess portions and a separation space of the leads.

9. The light emitting diode package of claim 7, wherein:
the leads further include a lower recess portion, respectively, and
the housing fills the lower recess portion of the light emitting diode package.

10. The light emitting diode package of claim 9,
wherein a depth of the upper recess portion is smaller than that of the lower recess portion.

11. The light emitting diode package of claim 7, wherein:
the housing has a cavity surrounded by inner side surfaces, and
an inlet width W2 of the cavity is greater than a width W4 of a bottom surface of the cavity.

12. The light emitting diode package of claim 11,
wherein a width W3 of an upper surface of the housing disposed between the cavity and a side surface of the housing is in a range of 0.15 mm to 0.2 mm.

13. The light emitting diode package of claim 11,
wherein the inner side surfaces of the cavity include a relatively steep inner side surface and a relatively gentle inner side surface, and the relatively gentle inner side surface is spaced apart from the bottom surface of the cavity.

14. The light emitting diode package of claim 13,
wherein the relatively gentle inner side surface is disposed between the relatively steep inner side surfaces.

15. A light emitting diode package, comprising:
a pair of leads;
a housing surrounding the leads and having a cavity;
a light emitting diode electrically connected to the leads; and
an encapsulant resin covering the light emitting diode, wherein:
each of the leads includes a light emitting diode mounting portion exposed to the cavity and an upper recess portion formed around the light emitting diode mounting portion,
the upper recess portion is covered with the housing, and
the light emitting diode mounting portion is covered by the light emitting diode.

16. The light emitting diode package of claim 15,
wherein an edge of a bottom surface of the cavity is disposed on the upper recess portion.

17. The light emitting diode package of claim 15,
wherein upper surfaces of the leads except for the light emitting diode mounting portions are covered with the housing.

18. The light emitting diode package of claim 15, wherein:
the encapsulant resin includes a wavelength conversion material,
the light emitting diode emits light having a peak wavelength in a range of 400 nm to 450 nm,
the housing is formed of a white epoxy molding compound, and
the encapsulant resin is formed of a methyl-based silicone resin or a middle refractive index silicone resin including a phenyl-based component and having a refractive index of 1.5 or less.

19. The light emitting diode package of claim 15,
wherein bottom surfaces of the leads occupy 50% or more of a bottom surface of the light emitting diode package.

20. The light emitting diode package of claim 15,
wherein edges of the bottom surface of the cavity is disposed on the upper recess portions.
